# EUROPÄISCHE PATENTSCHRIFT

(11) **EP 1 086 531 B1**
(45) Veröffentlichungstag und Bekanntmachung des Hinweises auf die Patenterteilung: **26.02.2003**
(21) Anmeldenummer: 99936386.4
(22) Anmeldetag: 01.06.1999
(51) Int. Cl.: H03K 19/003

(54) **LOGIKGATTER**
LOGIC GATE
PORTE LOGIQUE

(30) Priorität: 04.06.1998 DE 19825061
(43) Veröffentlichungstag der Anmeldung: 28.03.2001
(73) Patentinhaber: Infineon Technologies AG, 81669 München (DE)
(72) Erfinder: NEBEL, Gerhard, D-87509 Immenstadt (DE)
(74) Vertreter: Jannig, Peter, Dipl.-Ing.
(86) Internationale Anmeldenummer: DE9901618
(87) Internationale Veröffentlichungsnummer: WO99063668

(56) Entgegenhaltungen:
- WO-A-95/28035
- PATENT ABSTRACTS OF JAPAN vol. 1996, no. 10, 31. Oktober 1996 (1996-10-31) & JP 08 147971 A (FUJITSU LTD), 7. Juni 1996 (1996-06-07)
- PATENT ABSTRACTS OF JAPAN vol. 1996, no. 10, 31. Oktober 1996 (1996-10-31) & JP 08 162939 A (TOSHIBA MICROELECTRON CORP;TOSHIBA CORP), 21. Juni 1996 (1996-06-21)

## Beschreibung

Die Erfindung betrifft ein Logikgatter nach dem Oberbegriff des Anspruches 1.

Logikgatter sind die elementaren Grundbausteine digitaler Schaltungen und Systeme. Sie steuern den Signalfluß durch das gesamte System. Die Bezeichnung Gatter (Tor) weist daraufhin, dass sie durch die am Eingang anliegenden Signale geöffnet und geschlossen werden können und auf diese Weise entweder die Information weiterleiten oder ihre Weiterleitung verhindern. Nachfolgend werden Elemente der zweiwertigen (binären) Logik betrachtet, wobei die beiden logischen Signalwerte 0 und 1 durch die zwei unterschiedlichen Spannungspegel H bzw. HIGH (typisch 3,3 V oder 5 V) und L bzw. LOW (typisch 0,2 V bis etwa 1,4 V) unterschieden werden.

In der digitalen CMOS Schaltungstechnik sind neben den gewöhnlichen Grundgattern wie Inverter, NAND, NOR und Komplexgatter die sogenannten Transmissionsgatter (kurz T-Gatter) verbreitet. Gelegentlich tritt in diesem Zusammenhang auch der Begriff Pass-Transistor-Logik auf. Dabei handelt es sich um ein Transistorpaar bestehend aus einem N-MOS- und einem P-MOS-Transistor, die parallel geschaltet sind und invers an ihren Gates angesteuert werden. In der Regel besteht ein T-Gatter somit aus zwei Pfaden, einem N-Kanal-Transistor-Pfad, der niedrige bis mittlere Potentiale durchschalten kann, und einem P-Kanal-Transistor-Pfad, der mittlere bis hohe Potentiale durchschalten kann. Bei den bisher bekannten T-Gattern besteht jeder dieser Pfade nur aus einem Transistor. In einem Fall sind beide Transistoren gesperrt und stellen einen extrem hohen Widerstand zwischen ihren beiden Terminals dar. Im anderen Fall entsteht zwischen den Terminals eine leitende Verbindung mit einem endlichen Widerstand. Ein T-Gatter arbeitet also wie ein Schalter, allerdings mit der Einschränkung, dass nur Spannungspotentiale geschaltet werden können, die innerhalb der Betriebsspannung des T-Gatters liegen.

Die seit vielen Jahren übliche Betriebsspannung für den HIGH-Pegel von 5 V kann bei modernen CMOS-Prozessen nicht mehr eingehalten werden, da die Transistoren so klein geworden sind, dass bei 5 V die physikalische Grenze der maximalen Feldstärke überschritten wird. Aus diesem Grund arbeiten heute schon viele integrierte Schaltungen intern mit einer auf 3,3 V reduzierten Betriebsspannung für den HIGH-Pegel. Aus Kompatibilitätsgründen wird jedoch extern immer noch überwiegend mit 5 V Signalen gearbeitet. An der Schnittstelle zur Aussenwelt der digitalen Schaltung (in der Regel ist das die Padtreiberschaltung) sind daher Pegelwandler erforderlich. Bei Analogschaltungen führt das dazu, dass T-Gatter die Verbindung zur Aussenwelt herstellen müssen. Damit der volle Hub der analogen Signale von 5 V ausgenutzt werden kann, muss durch schaltungstechnische Maßnahmen ein T-Gatter so aufgebaut werden, dass an den anzusteuernden 3,3 V-Schalttransistoren der digitalen Schaltung keine Spannungen von 5 V auftreten, da sonst die Lebensdauer der in 3,3 V Prozessen hergestellten Transistoren deutlich herabgesetzt würde.

Bisher sind lediglich Realisierungen bei reinen Digitalschaltungen bekannt, die intern mit 3,3 V und extern mit 5 V arbeiten. A.P. Chandrakasan, A. Burstein, R.W. Brodersen, "A Low-Power Chipset for a Portable Multimedia I/O Terminal", IEEE J. of Solid-State Circuits, Vol.29, No. 12, S. 1415 - 1428, Dez. 1994 beschreiben beispielsweise eine Schaltung, die 1,1 V Signale auf den externen 5 V Hub verstärkt, wobei deren verwendete Technologie 5 V tauglich ist.

M.J.M. Pelgrom, E.C. Dijkmans, "A 3/5 volt compatible I/O buffer", Proc. ESSCIRC, pp. 140-143, Ulm 1994 beschreiben eine bidirektionale Schaltung in einer 3,3 V Technologie, die intern mit 3,3 V arbeitet und externe Signale bis zu 5 V zuläßt.

In beiden genannten Fällen handelt es sich um Pegelwandler, die die Verbindung zwischen zwei Schaltungsumgebungen mit unterschiedlichen Betriebsspannungen herstellen. Ein 5 V taugliches T-Gatter und die dafür erforderliche Ansteuerlogik in 3,3 V Technologie ist bisher nicht bekannt. Dies gilt auch für die WO 95/28035 A1, welche ein Logikgatter der im Oberbegriff des Anspruchs 1 beanspruchten Art beschreibt.

Der vorliegenden Erfindung liegt die Aufgabe zugrunde, eine Logikgatter-Schaltung anzugeben, die die Funktion eines T-Gatters übernehmen kann und so aufgebaut ist, dass 5 V Signale geschaltet werden können, ohne dass ein Transistor mit unzulässig hohen Spannungen betrieben wird.

Diese Aufgabe wird durch ein Logikgatter nach Anspruch 1 gelöst.

Das erfindungsgemäße Logikgatter zeichnet sich dadurch aus, dass es in jedem Ausgangspfad (3, 4) eine Schutzdiodeneinrichtung (MP11; MN11) zur Ableitung von Leckströmen aus den Schaltelementen aufweist.

Beispielsweise können zwei als Dioden geschaltete Transistoren die Leckströme der Begrenzungstransistoren abführen und einen unzulässigen Spannunsanstieg an den gesperrten Schalttransistoren verhindern, wenn das T-Gatter abgeschaltet ist. Durch den Einsatz solcher Dioden kann sichergestellt werden, dass durch Leckströme keine unzulässigen Gatespannungen an den Schalttransistoren auftreten.

Die Logikschaltung kann zwei wechselseitig arbeitende Ausgangspfade (Pull-Up- und Pull-Down-Pfad) besitzen, welche komplementär zueinander aufgebaute und arbeitende Schaltelemente aufweisen. Zweckmäßig können die beiden Ausgangspfade symmetrisch zueinander mit dem Ausgangsanschluss als Symmetriepunkt aufgebaut sein.

Ein wesentlicher Vorteil der erfindungsgemässen Anordnung besteht darin, dass ein solcherartig aufgebautes T-Gatter höhere Spannungen schalten kann, als ein konventionelles T-Gatter bei gleicher Spannungsfestigkeit der Einzeltransistoren. Mit der Erfindung gelingt es, in einer 3,3 V Fertigungstechnologie eine 5 V CMOS Logik aufzubauen, welche sich zur Ansteuerung von erfindungsgemäßen T-Gattern eignet, die in der Lage sind, (analoge) Signale mit einem Spannungshub von 5 V zu schalten.

Zur Ansteuerung des T-Gatters kann nach einer bevorzugten Ausführung der Erfindung ein CMOS Inverter vorgesehen sein, der am Eingang 5 V Signale verarbeiten kann und am Ausgang wiederum den vollen 5 V Hub liefert. Auch diese Schaltung ist so konzipiert, dass die Spannung an den Transistoren immer deutlich unter 5 V bleibt. Durch geeignete Erweiterung kann aus dem Inverter ein NAND- oder ein NOR-Gatter und dergleichen aufgebaut werden. Die Kombination dieser beiden Erweiterungen kann schließlich zu einem Komplexgatter führen. Die Erfindung umfasst damit eine komplette CMOS-Logik inklusive T-Gatter, die mit 5 V Signalen arbeitet und in einem modernen 3,3 V Prozess realisiert werden kann.

Bei einer weiteren bevorzugten Ausführung der Erfindung kann vorgesehen sein, dass die Logikschaltung in jedem Ausgangspfad ein weiteres, drittes Schaltelement aufweist, welches in Reihe mit den beiden ersten und zweiten Schaltelement verbunden ist.

Weitere Vorteile und Zweckmäßigkeiten der Erfindung ergeben sich aus den Unteransprüchen.

Nachfolgend wird die Erfindung anhand mehrerer in der Zeichnung dargestellter Ausführungsbeispiele weiter erläutert. Im Einzelnen zeigen die schematischen Darstellungen in:
- Figur 1: ein Schaltbild eines Logikgatters als Inverter nach einem ersten Ausführungsbeispiel;
- Figur 2: ein Schaltbild eines Logikgatters als NAND-Gatter nach einem zweiten Ausführungsbeispiel;
- Figur 3: ein Schaltbild eines Logikgatters als Transmissionsgatter nach einem dritten Ausführungsbeispiel; und
- Figur 4: ein Schaltbild einer Steuerschaltung mit einem Transmissionsgatter nach einem vierten Ausführungsbeispiel.

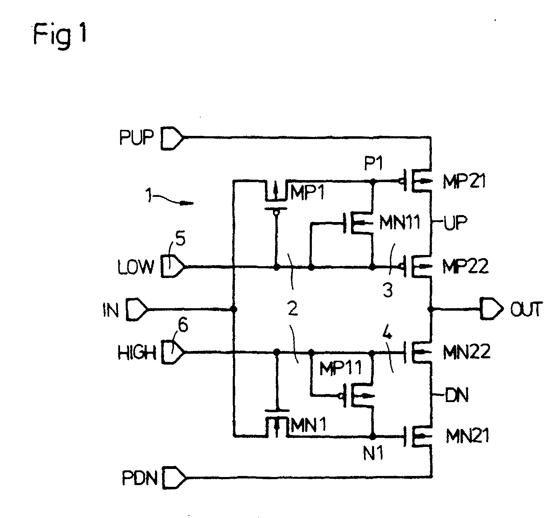

In Figur 1 ist ein Logikgatter 1 als Inverter (NICHT-Gatter) dargestellt, welches mit 5 V Signalen arbeitet und in einer 3,3 V Technologie gefertigt werden kann. Das Logikgatter 1 besitzt einen Eingangsanschluss IN, an dem ein Eingangssignal in zwei möglichen logischen Signalwerten HIGH = 5 V und LOW = 0 V anliegt, und einen Ausgangsanschluss OUT zur Ausgabe eines Ausgangssignales mit einem gegenüber dem Eingangssignal inversen Signalwert LOW oder HIGH, und eine zwischen dem Eingangs- und Ausgangsanschluss vorgesehene Logikschaltung 2, die aus zwei wechselseitig arbeitenden Ausgangspfaden 3 und 4, den Pull-Up- und Pull-Down-Pfaden besteht. Die beiden Pfade 3 und 4 weisen komplementär zueinander aufgebaute und arbeitende Schaltelemente auf. Die Logikschaltung 2 ist durch ein die Logikspannungspegel HIGH und LOW übersteigendes Versorgungspotential PUP versorgt. Jeder Ausgangspfad 3 und 4 der Logikschaltung 2 besitzt zwei in Reihe geschaltete, als Spannungsteiler geschaltete P-Kanal-MOS-Schalttransistoren MP21 und MP22 bzw. N-Kanal-MOS-Schalttransistoren MN21 und MN22. An den Anschlüssen PUP und PDN wird die Betriebsspannung zugeführt. In der Regel liegt PDN auf 0 V, dem Bezugspotential, und PUP auf 5 V, der maximalen Betriebsspannung. Zur Ansteuerung des nachfolgend erklärten T-Gatters sind Signale kleiner als 5 V erforderlich. Das wird erreicht, indem PUP bzw. PDN an eine Hilfsspannung angeschlossen wird. An den Anschlüssen 5 (HIGH) und 6 (LOW) werden die Hilfsspannungen zugeführt. Sie betragen 1,4 V für LOW und 3,6 V für HIGH gegenüber dem Bezugspotential. Der Realisierung liegt ein N-Wannen Prozess zugrunde, wobei die (nicht dargestellten) Wannen an 5 V und das (nicht dargestellte) Substrat an 0 V gelegt werden. Der Pull-Up-Zweig 3 und der Pull-Down-Zweig 4 sind symmetrisch zueinander, wobei den N-Kanal-Transistoren jeweils P-Kanal-Transistoren entsprechen und umgekehrt.

Zur Erläuterung der Funktionsweise der Schaltung nach Figur 1 genügt es aus Symmetriegründen, nur den Pull-Down-Zweig 4 zu betrachten.

Wenn der Invertereingang IN auf 5 V liegt, zieht der Transistor MN1 den Knoten N1 bis 3,6 V (HIGH) hoch. Ab diesem Spannungswert schnürt sich der Transistor MN1 ab (UGS = 0) und verhindert einen weiteren Spannungsanstieg am Knoten N1. Damit ist sichergestellt, dass die Gate-Source-Spannung am Schalttransistor MN21 nicht über 3,6 V hinaus geht. Der Transistor MN21 zieht den Knoten DN nach unten, wodurch auch der Transistor MN22 zu leiten beginnt und den Inverterausgang OUT nach 0 V zieht. Ohne den Transistor MP11 würden Leckströme im statischen Fall das Gate des Transistors MN21 weiter aufladen, da das Gate eines MOS-Transistors besser isoliert als ein abgeschalteter Transistor. Die Diode MP11 beginnt zu leiten, wenn das Potential am Knoten N1 den Potentialwert HIGH (3,6 V) übersteigt, und verhindert damit einen weiteren Potentialanstieg am Knoten N1.

Liegt der Invertereingang IN auf 0 V, leitet der Transistor MN1 und entlädt den Knoten N1. Damit wird der Schalttransistor MN21 gesperrt. In analoger Weise wie oben beschrieben arbeitet nun der Pull-Up-Zweig 3. Der Knoten P1 geht von 5 V herunter auf 1,4 V (LOW) und steuert den Schalttransistor MP21 durch. Über den Transistor MP22 wird anschließend der Inverterausgang OUT auf volle 5 V hochgezogen. Der Knoten DN folgt aber nur bis 3,6 V, weil sich ab diesem Wert der Transistor MN22 abschnürt. Dieser Transistor begrenzt also den Spannungsanstieg an dem Knoten DN in gleicher Weise wie der Transistor MN1 den Spannungsanstieg an dem Knoten N1 begrenzt. Gegebenenfalls vorhandene Leckströme sind hier unprobiematisch, da sie nicht auf ein isoliertes Gate, sondern auf einen ebenso leckstrombehafteten, gesperrten Transistor MN21 wirken. Sollte der Knoten DN auf höhere Spannungswerte als HIGH ansteigen, wird die Gate-Source-Spannung des Transistors MN22 negativ, so dass dieser Transistor noch weniger leitet als der Transistor MN21, dessen Gate-Source-Spannung 0 V beträgt. Damit ist ein weiterer Spannungsanstieg am Knoten DN ausgeschlossen.

Die Funktionsweise der Inverter-Schaltung nach Figur 1 kann wie folgt zusammengefasst werden. Die Transistoren MN21 und MP21 bilden die Schalttransistoren für den Pull-Down-Zweig 4 bzw. Pull-Up-Zweig 3 und liegen mit ihren Source-Anschlüssen an den Betriebsspannungen PUP bzw. PDN. Die PDN- bzw. PUP-Transistoren MN1 und MP1 begrenzen die Gatespannung, und die Transistoren MN22 und MP22 begrenzen die Drainspannung der Schalttransistoren. Die Dioden MN11 und MP11 leiten die Leckströme von den Transistoren MN1 bzw. MP2 ab. Durch die Reihenschaltung von drei N-Kanal-Transistoren MN1, MN21, MN22 im einen und drei P-Kanal-Transistoren MP1, MP21, MP22 im anderen Pfad wird nach der Ausführung gemäß Figur 1 erreicht, dass sich die hohe Versorgungsspannung von beispielsweise 5 V auf die einzelnen Transistoren aufteilt. Die vier außenliegenden Transistoren MN1, MN22; MP1, MP22 begrenzen die Spannung an den innenliegenden Schalttransistoren MN21 bzw. MP21. Mit einer solchen Schaltung ist es möglich, 5 V Signale zu schalten, auch wenn die einzelnen Transistoren MN1, MN21, MN22, MP1, MP21, MP22 nur für 3,3 V ausgelegt sind.

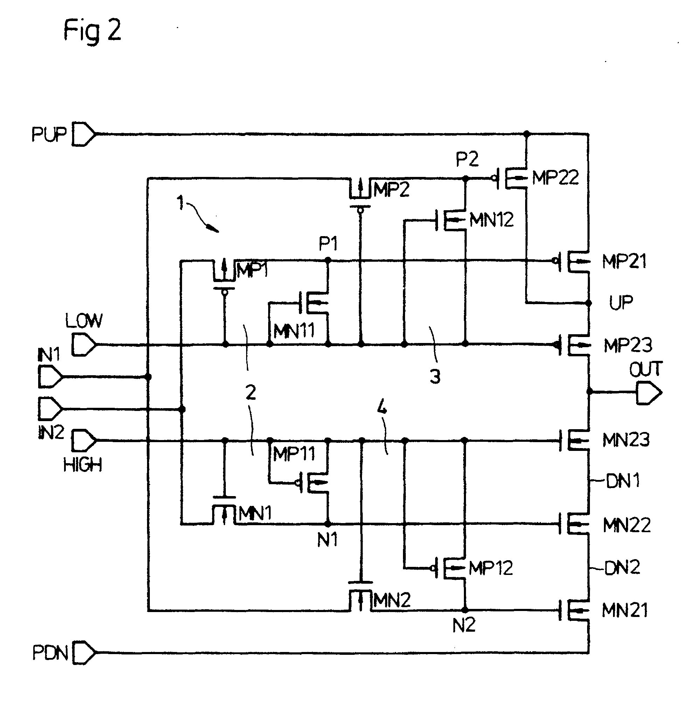

Durch entsprechende Erweiterung entsteht aus dem Inverter nach Figur 1 ein NAND-Gatter nach Figur 2, indem zwei N-Kanal-Pull-Down Transistoren in Reihe und zwei P-Kanal-Pull-Up Transistoren parallel geschaltet werden. Gleiche Bezugsziffern bezeichnen analoge Schaltungsteile. Die Transistoren MN21 und MN22 sind in Reihe geschaltet und werden von dem Transistor MN23 vor zu hohen Spannungen geschützt. Die Transistoren MP21 und MP22 liegen parallel und werden von dem Transistor MP23 vor zu niedrigen Spannungspotentialen am Knoten UP geschützt. Jeder Schalttransistor MP21 bzw. MN21, sowie MP22 bzw. MN22 verfügt über seine eigene Schutzschaltung in Form der Transistoren P1 bzw. N1, sowie P2 bzw. N2 an seinem Gate.

Durch eine geeignete Reihenschaltung der P-Transistoren und Parallelschaltung der N-Transistoren kann auf analoge Weise ein (in den Figuren nicht näher dargestelltes) NOR-Gatter realisiert werden.

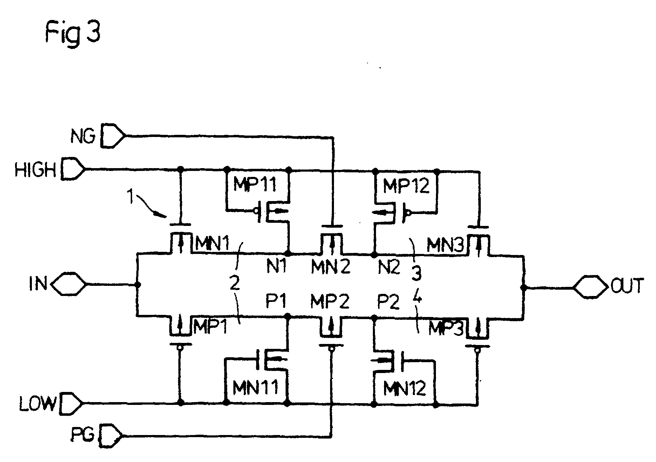

In Figur 3 ist ein Transmissionsgatter bzw. T-Gatter nach einem dritten Ausführungsbeispiel der Erfindung dargestellt. Da ein T-Gatter bidirektional arbeitet, ist keine eindeutige Zuordnung von Drain und Source möglich. Aus diesem Grund werden diese Transistoranschlüsse sowie die Ein- und Ausgänge IN bzw. OUT des T-Gatters als Terminals bezeichnet. Das in Figur 3 gezeigte T-Gatter kann 5 V Signale schalten und ist mit 3,3V Transistoren aufgebaut. Die Transistoren MN2 und MP2 stellen die Schalttransistoren des T-Gatters, die Knoten IN und OUT die beiden Terminals dar. Damit das T-Gatter sperrt, muss der Steueranschluss NG auf 0 V und der Steueranschluss PG auf 5 V liegen. In diesem Fall verhindern die Transistoren MN1, MP11 und die Transistoren MN3, MP12, dass die Knoten N1 bzw. N2 (Terminals des Schalttransistors MN2) über das Potential HIGH ansteigen, genau wie beim Inverter nach Figur 1. Die Transistoren MP1, MN11 und MP3, MN12 verhindern, dass die Knoten P1 und P2 unter das Potential LOW abfallen. Damit wird erreicht, dass die Spannung zwischen dem Gate und den Terminals der Schalttransistoren den Wert von 3,6 V nicht übersteigen.

Damit das T-Gatter durchschaltet, muss der Knoten NG auf hohes und der Knoten PG auf niedriges Potential gebracht werden. Niedrige bis mittlere Potentiale gelangen über die N-Pfade der Transistoren MN1, MN2 und MN3, mittlere bis hohe Potentiale gelangen über den P-Pfad der Transistoren MP1, MP2 und MP3 von einen zum anderen Terminal des T-Gatters. Demnach darf der Knoten NG die maximal zulässige Gate-Source-Spannung (ca. 3,6 V) nicht überschreiten. Der Knoten PG darf maximal um ca. 3,6 V unterhalb des Wertes VDD = 5 V liegen (1,4 V). Besonders kritisch bezüglich eines möglichst kleinen Einwiderstandes wird es bei mittleren Potentialen (2,5 V). In diesem Fall leiten beide Pfade, wobei die Gate-Source-Spannung der Schalttransistoren nur 3,6 V - 2,5 V bzw. 2,5 V - 1,4 V = 1,1 V beträgt. Um einen möglichst kleinen Einwiderstand zu erzielen, ist es wichtig, dass die Gate-Source-Spannung möglichst groß wird. Das heißt, dass der Potentialwert HIGH möglichst hoch und der Potentialwert LOW möglichst niedrig liegen sollte. Andererseits aber darf die maximal zulässige Gate-Source-Spannung nicht überschritten werden. Bei einem 3,3 V Prozess kann unter Berücksichtigung von ±10 % Toleranz durchaus 3,6 V gewählt werden. Das führt zu den gewählten Spannungen von 3,6 V für HIGH und 5 V - 3,6 V = 1,4 V für LOW.

In allen dargestellten Beispielschaltungen (T-Gatter, Inverter, NAND, NOR) werden die Hilfsspannungen nur an die Gates von MOS-Transistoren geführt. Dadurch sind die Anforderungen bezüglich der Leistung für die Hilfsspannungen sehr gering. Statisch werden diese Spannungen praktisch nicht belastet, so dass sie ohne großen Aufwand auf dem Chip erzeugt werden können. Spannungseinbrücke durch dynamische Belastung können mit einer geeignet dimensionierten Kapazität gegen die Betriebsspannungen abgefangen werden.

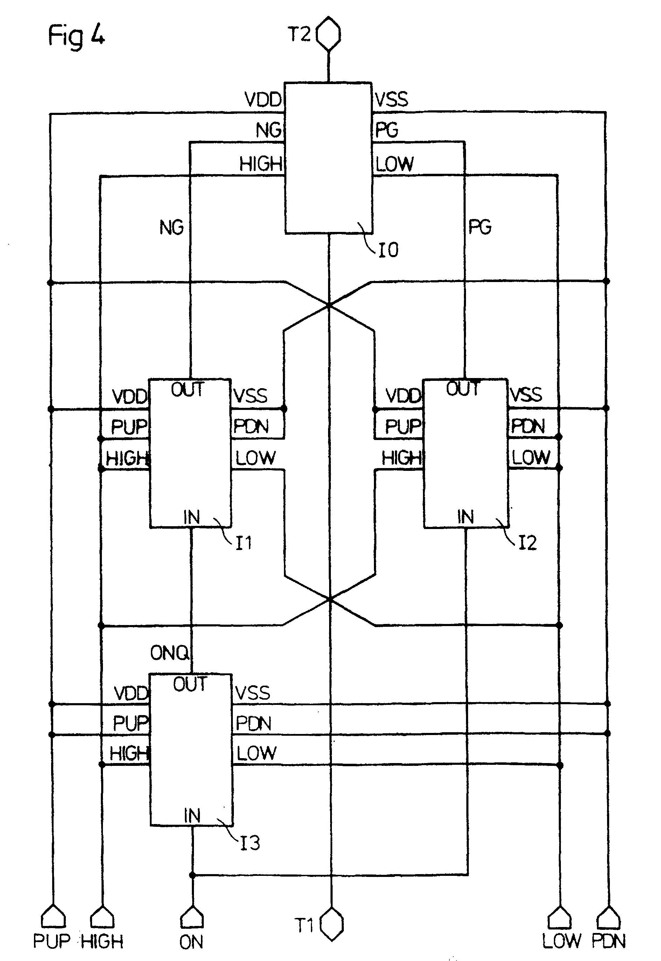

In Figur 4 ist die Zusammenschaltung eines T-Gatters 10 nach Figur 3 mit drei Invertern I1, I2, I3 nach Figur 1 dargestellt. Der Inverter I1 steuert den Knoten NG und ist mit seinem Pull-Up-Zweig PUP nicht an 5 V, sondern nur an 3,6 V angeschlossen. Damit liefert er Ausgangsspannungen von 0 V (logisch 0) und 3,6 V (logisch 1), wie sie zur Ansteuerung des Knotens NG erforderlich sind. Der Inverter I2 liefert dagegen Ausgangsspannungen von 1,4 V (logisch 0) und 5 V (logisch 1) zur Ansteuerung des Knotens PG. Der Inverter I3 akzeptiert an seinem Eingang 5 V Signale und liefert am Ausgang wiederum 5 V Signale und sorgt für die inverse Ansteuerung der Inverter von I1 und I2. Liegen 5 V am Steuereingang ON, schaltet das T-Gatter durch und es bildet sich ein endlicher Widerstand zwischen den beiden Terminals T1 und T2. Liegt ON auf 0 V, sperrt das T-Gatter und zwischen den beiden Terminals T1 und T2 bildet sich ein sehr hoher Widerstand.

Die Hilfsspannungen werden bei der Gesamtschaltung nach Figur 4 zwar auch an die Inverteranschlüsse PUP und PDN geführt, die Inverter steuern jedoch wieder nur die Gates von MOS-Transistoren an, so dass auch bei dieser Schaltung keine statischen Ströme von den Hilfsspannungen geliefert werden müssen.

## Patentansprüche

1. Logikgatter mit wenigstens einem Eingangsanschluss (IN), an dem ein Eingangssignal in zwei möglichen logischen Signalwerten anliegt, und mit wenigstens einem Ausgangsanschluss (OUT) zur Ausgabe eines Ausgangssignales mit einem logischen Signalwert, wobei den beiden möglichen logischen Signalwerten des Ausgangssignales zwei unterschiedliche Logikspannungspegel (HIGH, LOW) zugeordnet sind, und einer zwischen dem Eingangs- und Ausgangsanschluss (IN, OUT) vorgesehenen Logikschaltung (2) mit mehreren, nach den Logikspannungspegeln (HIGH, LOW) arbeitenden bzw. hergestellten Schaltelementen, insbesondere Schalttransistoren, welche Logikschaltung (2) durch ein die Logikspannungspegel (HIGH, LOW) übersteigendes Versorgungspotential (PUP) versorgt ist, wobei die Logikschaltung (2) in ihrem dem Ausgangsanschluss (OUT) zugeordneten Ausgangspfad (3, 4) wenigstens zwei in Reihe geschaltete, als Spannungsteiler wirkende Schaltelemente (MN21, MN22; MP21, MP22), insbesondere Schalttransistoren, aufweist,
**dadurch gekennzeichnet,**
**dass** die Logikschaltung in jedem Ausgangspfad (3, 4) eine Schutzdiodeneinrichtung (MP11; MN11) zur Ableitung von Leckströmen aus den Schaltelementen aufweist.

2. Logikgatter nach Anspruch 1,
**dadurch gekennzeichnet,**
**dass** die Logikschaltung (2) zwei wechselseitig arbeitende Ausgangspfade (3, 4) (Pull-Up- und Pull-Down-Pfad) besitzt, welche komplementär zueinander aufgebaute und arbeitende Schaltelemente aufweisen.

3. Logikgatter nach Anspruch 1 oder 2,
**dadurch gekennzeichnet,**
**dass** die beiden Ausgangspfade (3, 4) symmetrisch zueinander mit dem Ausgangsanschluss (OUT) als Symmetriepunkt aufgebaut sind.

4. Logikgatter nach Anspruch 1 bis 3,
**dadurch gekennzeichnet,**
**dass** die Logikschaltung (2) in jedem Ausgangspfad (3, 4) ein weiteres, drittes Schaltelement (MN1; MP1) aufweist, welches in Reihe mit den beiden ersten und zweiten Schaltelementen verbunden ist.

5. Logikgatter nach einem der Ansprüche 1 bis 4,
**dadurch gekennzeichnet,**
**dass** die beiden Logikspannungspegel (HIGH, LOW) 3,6 Volt und 1,4 Volt und das Versorgungspotential (PUP) 5 Volt beträgt.

6. Logikgatter nach einem der Ansprüche 1 bis 5,
**dadurch gekennzeichnet,**
**dass** die Schaltelemente der Logikschaltung (2) in 3,3 Volt CMOS Technologie hergestellt sind.

7. Logikgatter nach einem der Ansprüche 1 bis 6,
**dadurch gekennzeichnet,**
**dass** die Logikschaltung (2) als NICHT- (Inverter), AND-, NAND-, OR-, EXOR-, NOR-Gatter oder Transmissions-Gatter (T-Gatter) ausgebildet ist.

## Claims

1. Logic gate having at least one input terminal (IN) to which an input signal with two possible logic signal values is applied, and having at least one output terminal (OUT) for outputting an output signal with a logic signal value, two different logic voltage levels (HIGH, LOW) being assigned to the two possible logic signal values of the output signal, and having a logic circuit (2) which is provided between the input and output terminals (IN, OUT) and has a plurality of switching elements, in particular switching transistors, which operate, or are manufactured, according to the logic voltage levels (HIGH, LOW), which logic circuit (2) is supplied by a supply potential (PUP) which exceeds the logic voltage level (HIGH, LOW), the logic circuit (2) having, in its output path (3, 4) which is assigned to the output terminal (OUT), at least two switching elements (MN21, MN22; MP21, MP22), in particular switching transistors, which are connected in series and act as voltage dividers, **characterized in that** the logic circuit has, in each output path (3, 4), a protective diode device (MP11; MN11) for conducting away leakage currents from the switching elements.

2. Logic gate according to Claim 1, **characterized in that** the logic circuit (2) has two alternately operating output paths (3, 4) (pull-up and pull-down paths) which have switching elements which are constructed and operate in a complementary fashion.

3. Logic gate according to Claims 1 or 2, **characterized in that** the two output paths (3, 4) are constructed symmetrically with respect to one another with the output terminal (OUT) as the point of symmetry.

4. Logic gate according to Claims 1 to 3, **characterized in that** the logic circuit (2) has, in each output path (3, 4), a further, third switching element (MN1; MP1) which is connected in series with the two first and second switching elements.

5. Logic gate according to one of Claims 1 to 4, **characterized in that** the two logic voltage levels (HIGH, LOW) are 3.6 volts and 1.4 volts, and the supply potential (PUP) is 5 volts.

6. Logic gate according to one of Claims 1 to 5, **characterized in that** the switching elements of the logic circuit (2) are manufactured using 3.3 volt CMOS technology.

7. Logic gate according to one of Claims 1 to 6, **characterized in that** the logic circuit (2) is embodied as a NOT (inverter), AND, NAND, OR, EXOR, NOR gate or transmission gate (T gate).

## Revendications

1. Porte logique comprenant au moins une borne d'entrée (IN) à laquelle est appliqué un signal d'entrée pouvant prendre deux valeurs logiques et au moins une borne de sortie (OUT) pour délivrer un signal de sortie ayant une valeur de signal logique, deux niveaux de tension logiques différents (HAUT, BAS) étant associés aux deux valeurs de signal logique possibles du signal de sortie, et un circuit logique (2) prévu entre la borne d'entrée et la borne de sortie (IN, OUT) comprenant plusieurs éléments de commutation fonctionnant ou fabriqués d'après les niveaux de tension logiques (HAUT, BAS), plus précisément des transistors de commutation, lequel circuit logique (2) est alimenté par un potentiel d'alimentation (PUP) supérieur au niveau de tension logique (HAUT, BAS), le circuit logique (2) présentant au moins deux éléments de commutation (MN21, MN22 ; MP21, MP22) branchés en série et faisant office de diviseur de tension dans sa branche de sortie (3, 4) affectée à la borne de sortie (OUT), **caractérisée en ce que** le circuit logique présente dans chaque branche de sortie (3, 4) un dispositif à diodes de protection (MP11 ; MN11) pour dériver les courants de fuite en provenance des éléments de commutation.

2. Porte logique selon la revendication 1, **caractérisée en ce que** le circuit logique (2) possède deux branches de sortie (3, 4) fonctionnant en alternance (branche à commutation au niveau HAUT et branche à commutation au niveau BAS), lesquelles présentent des éléments de commutation ayant des structures et des fonctionnements complémentaires l'un par rapport à l'autre.

3. Porte logique selon la revendication 1 ou 2, **caractérisée en ce que** les deux branches de sortie (3, 4) sont construites de manière symétrique l'une par rapport à l'autre avec la borne de sortie (OUT) comme point de symétrie.

4. Porte logique selon la revendication 1 à 3, **caractérisée en ce que** le circuit logique (2) présente dans chaque branche de sortie (3, 4) un troisième élément de commutation supplémentaire (MN1 ; MP1) qui est branché en série avec les deux premiers et deuxièmes éléments de commutation.

5. Porte logique selon l'une des revendications 1 à 4, **caractérisée en ce que** les deux niveaux de tension logiques (HAUT, BAS) sont de 3,6 volts et de 1,4 volts et le potentiel d'alimentation (PUP) est de 5 volts.

6. Porte logique selon l'une des revendications 1 à 5, **caractérisée en ce que** les éléments de commutation du circuit logique (2) sont fabriquées en technologique CMOS 3,3 volts.

7. Porte logique selon l'une des revendications 1 à 6, **caractérisée en ce que** le circuit logique (2) est réalisé sous la forme d'une porte NON (inverseur), AND, NAND, OR, EXOR, NOR ou d'une porte de transmission (porte T).
